# EUROPÄISCHE PATENTANMELDUNG

(11) **EP 4 465 775 A1**
(43) Veröffentlichungstag der Anmeldung: **20.11.2024**
(21) Anmeldenummer: 24171702.4
(22) Anmeldetag: 22.04.2024
(51) Int. Cl.: H05K 3/00, H05K 3/36

(54) **BAUTEILANORDNUNG SOWIE WERKZEUG UND VERFAHREN ZUR HERSTELLUNG EINER SOLCHEN BAUTEILANORDNUNG**

(30) Priorität: 15.05.2023 DE 102023204543
(71) Anmelder: VOLKSWAGEN AG, 38440 Wolfsburg (DE)
(72) Erfinder: Rang, Oliver, 34132 Kassel (DE); Gronda, Raffael, 34131 Kassel (DE); Zellmer, Dr. Mario, 34131 Kassel (DE); Schnier, Michael, 34295 Edermünde (DE)

(57) **Zusammenfassung**

Die Erfindung betrifft eine Bauteilanordnung mit einem Bauteil, etwa einer Leiterplatine (1), das an einen Bauteilträger (3), insbesondere aus einem Nichteisenmetall mit niedrigem Schmelzpunkt, etwa Aluminium, gefügt ist, wobei das Bauteil (1) auf einer Sockelfläche (5) des Bauteilträgers (3) liegt, von der ein Materialdom (7) abragt, der durch eine Durchgangsbohrung (9) des Bauteils (1) geführt ist. Erfindungsgemäß ist ein die Durchgangsbohrung (9) des Bauteils (1) überragender Materialdom-Kopf (11) im Fügeprozess nach Art eines Rührreibschweißens oder einer anderen/ ähnlichen Art zur Temperaturerzeugung durch Reibung (durch Rotation und Anpressdruck) oder auch mit einer anderen Form der Temperaturerzeugung plastifizierbar, so dass sich der Materialdom-Kopf (11) ausweitet. Zwischen dem Rand des ausgeweiteten Materialdom-Kopfes (11) und der Sockelfläche (5) ist ein Hinterschnitt gebildet, in dem das Bauteil (1) formschlüssig gehaltert ist.

## Beschreibung

Die Erfindung betrifft eine Bauteilanordnung mit einer Leiterplatine und einem Bauteilträger nach dem Oberbegriff des Anspruches 1. Die Erfindung betrifft zudem ein Werkzeug nach Anspruch 9 sowie ein Verfahren nach Anspruch 10 zur Herstellung einer solchen Bauteilanordnung.

Die Antriebseinheit eines elektrisch betriebenen Fahrzeugs weist einen Pulswechselrichter auf, dessen Komponenten, das heißt unter anderem eine Leiterplatine sowie Leistungsmodule, an einem Montageträger montierbar sind.

Eine gattungsgemäße Bauteilanordnung weist eine solche Leiterplatine auf, die auf dem Montageträger gefügt ist. Hierzu liegt die Leiterplatine auf einer Sockelfläche des Montageträgers, von der ein Materialdom abragt. Dieser ist durch eine Durchgangsbohrung der Leiterplatine geführt. Im Materialdom ist ein Gewindesackloch mit Innengewinde ausgebildet, in das eine Befestigungsschraube einschraubbar ist. In diesem Fall ist die Leiterplatine zwischen dem Schraubkopf der Befestigungsschraube und der Sockelfläche des Montageträgers mit einer Klemmkraft verspannt. Um eine Beschädigung der Leiterplatine zu vermeiden, muss die von der Befestigungsschraube auf die Leiterplatine ausgeübte Klemmkraft auf einen entsprechend geringen Kraftwert eingestellt werden. In einer alternativen Herstellungsvariante kann die Befestigungsschraube als eine selbstfurchende Schraube realisiert sein, die in den aus Vollmaterial gebildeten Materialdom einschraubbar ist.

In beiden Herstellungsvarianten muss die Befestigungsschraube als separates Bauteil vorgehalten werden. Zudem gestaltet sich in beiden Herstellungsvarianten die Einstellung der von der Befestigungsschraube auf die Leiterplatine ausgeübten Klemmkraft als fertigungstechnisch aufwendig.

Aus der US 2016/0286667 A1 ist eine Bauteilanordnung bekannt, die ein Fixierelement zum elektrischen und mechanischen Anbinden einer Platine an wenigstens einen Pin einer Stromschiene aufweist, wobei die Platine in deren Einbauzustand auf den wenigstens einen Pin aufgesteckt ist. Das Fixierelement ist so ausgebildet, dass an der Platine wenigstens ein Pin im Einbauzustand formschlüssig verriegelt ist. Aus der US 2019/0174641 A1 ist eine Bauteilanordnung für Verdrahtungselemente bekannt. Diese umfasst ein flaches Verdrahtungs-Element, das durch Bedecken eines äußeren Umfangs eines gürtelartigen flachen Leiters mit einer isolierenden Beschichtung gebildet wird; einen Bolzen, der senkrecht zu einer flachen Leiteroberfläche des flachen Leiters verbunden ist, die an einer Zwischenposition des flachen Verdrahtungselementes freiliegt.

Die Aufgabe der Erfindung besteht darin, eine Bauteilanordnung sowie ein Werkzeug und ein Verfahren zur Herstellung einer solchen Bauteilanordnung bereitzustellen, die im Vergleich zum Stand der Technik fertigungstechnisch einfach sowie prozesssicher herstellbar ist.

Die Aufgabe ist durch die Merkmale des Anspruches 1, 9 oder 10 gelöst. Bevorzugte Weiterbildungen der Erfindung sind in den Unteransprüchen offenbart.

Nachfolgend sind die wesentlichen Aspekte der Erfindung anhand einer Bauteilanordnung beschrieben, die speziell aus einer Leiterplatine und einem Montageträger aufgebaut ist. Die Erfindung ist jedoch nicht auf diese spezielle Bauteilkombination begrenzt. Alternativ dazu ist die Erfindung auch auf andere ähnliche Bauteileumfänge anwendbar, etwa auf Flachprofile, Bleche, Steckerelemente, geeignete Bauteile etc., die an einem Bauteilträger befestigbar sind.

Die Erfindung geht von einer Bauteilanordnung mit einer Leiterplatine aus, die an einen Montageträger gefügt ist. Die Leiterplatine liegt auf einer Sockelfläche des Montageträgers, von der ein Materialdom abragt, der durch eine Durchgangsbohrung der Leiterplatine geführt ist. Gemäß dem kennzeichnenden Teil des Anspruches 1 wird auf die Bereitstellung einer Befestigungsschraube zur Anbindung der Leiterplatine auf den Montageträger verzichtet. Anstelle dessen wird der die Durchgangsbohrung der Leiterplatine überragende Materialdom-Kopf im Fügeprozess nach Art eines Rührreibschweißens oder einer anderen/ ähnlichen Art zur Temperaturerzeugung durch Reibung (durch Rotation und Anpressdruck) oder auch mit einer anderen Form der Temperaturerzeugung (ähnlich dem Heißverstemmen) plastifiziert, damit sich der Materialdom-Kopf ausweitet und anformt. Zwischen dem Rand des ausgeweiteten Materialdom-Kopfes und der Sockelfläche bildet sich ein Hinterschnitt, in dem die Leiterplatine formschlüssig gehaltert ist. Der Fügeprozess wird mittels eines Stempels durchgeführt. Dieser wird während des oben beschriebenen Fügevorgangs gegen die Kopfoberseite des Materialdom-Kopfes gedrückt. Mittels der dadurch erzeugten Reibungswärme wird der Materialdom-Kopf plastifiziert und ausgeweitet/ angeformt. Die im Zusammenbauzustand auf die Leiterplatine wirkende Klemmkraft wird prozesstechnisch mittels eines entsprechend bemessenen Stempel-Anpressdruckes eingestellt.

In einer bevorzugten technischen Umsetzung kann der Materialdom ein an der Kopfoberseite offenes Hohlprofil aufweisen. Das Hohlprofil kann beispielhaft als ein Sackloch ausgebildet sein, das mit einer Sackloch-Tiefe an einem zurückgesetzten Sackloch-Grund abschließt. Alternativ dazu kann das Hohlprofil auch als ein Durchgangsloch realisiert sein.

Um die Ausbildung des ausgeweiteten Materialdom-Kopfes zu unterstützen, kann der Stempel an seiner, dem Materialdom-Kopf zugewandten Seite eine konisch zulaufende Stempelspitze aufweisen. Die Stempelspitze ist derart bemessen, dass diese während des Fügevorgangs in das Hohlprofil des Materialdoms eintaucht. Dadurch kann die Stempelspitze mit ihrem radial äußeren Mantel den Öffnungsrandbereich des Materialdom-Kopfes bei gleichzeitiger Plastifizierung radial nach außen drücken.

Gemäß einer ersten Ausführungsvariante kann der Stempel während des Fügevorgangs zusätzlich mittels einer Heizeinrichtung beheizt werden. In diesem Fall erfolgt also - neben der Reibungswärme - eine zusätzliche Wärmeableitung von der stempelseitigen Heizeinrichtung in den Materialdom-Kopf, um diesen zu plastifizieren. Kerngedanke der Erfindung ist jedoch, dass der Stempel während des Fügevorgangs nach Art eines Rührreibschweißens unter Rotation mit einer axialen Fügekraft (d.h. einem Anpressdruck) gegen die Kopfoberseite des Materialdom-Kopfes gepresst wird. Dadurch wird Reibungswärme erzeugt, die den Materialdom-Kopf plastifiziert.

In der gefügten Bauteilanordnung ist die Leiterplatte mit einer vordefinierten, ausreichend geringen Klemmkraft zwischen dem Rand des ausgeweiteten Materialdom-Kopfes und der Sockelfläche verspannt. Um eine ausreichende Reduzierung der auf die Leiterplatine wirkenden Klemmkraft in einfacher Weise zu bewirken, kann folgende Maßnahme getroffen sein: So kann der Materialdom von einer bauteilsteifen Stützhülse umgeben sein. Diese ist mit ihren Stirnseiten zwischen der Unterseite des Rands des ausgeweiteten Materialdom-Kopfes und der Sockelfläche abgestützt. Dadurch wird die sich beim Fügevorgang aufbauende Klemmkraft zumindest teilweise in die Stützhülse eingeleitet, so dass der Materialdom entlastet wird.

Für einen weiteren Schutz der Leiterplatine gegen eine übermäßig große Klemmkraft kann zudem folgende Maßnahme getroffen sein: So kann die Stützhülse an seiner, dem Materialdom-Kopf zugewandten Stirnseite in einen rechtwinklig nach außen abragenden Stützflansch übergehen. In diesem Fall ist ein besonders spannungsanfälliger Öffnungsrandbereich der Durchgangsbohrung der Leiterplatine im Wesentlichen spannungsfrei in einem Inneneckbereich zwischen dem Stützflansch und dem Außenumfang der Stützhülse positioniert.

In einer weiteren Ausführungsvariante kann die Hohlprofil-Wandstärke des Materialdoms variieren, um den beim Fügevorgang erforderlichen Anpressdruck bzw. die erforderliche Wärmebeaufschlagung zu minimieren. In diesem Fall kann bevorzugt der als Hohlprofil ausgebildete Materialdom einen in der Durchgangsbohrung der Leiterplatine befindlichen Mittelbereich mit großer Hohlprofil-Wandstärke aufweisen, der in den Materialdom-Kopf übergeht, der eine demgegenüber reduzierte Hohlprofil-Wandstärke aufweist und dadurch einfacher plastifizierbar ist.

Nachfolgend sind Ausführungsbeispiele der Erfindung anhand der beigefügten Figuren beschrieben.

Es zeigen:

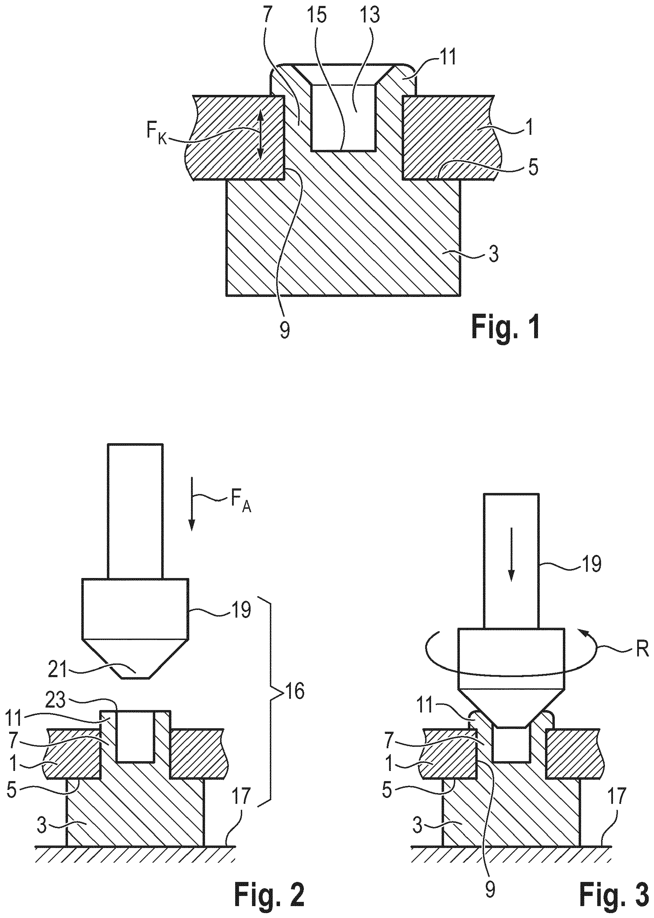

Figuren 1 bis 9 jeweils unterschiedliche Ausführungsvarianten zur Herstellung der erfindungsgemäßen Bauteilanordnung.

In der Figur 1 ist in einer Teilschnittansicht eine Bauteilanordnung im Zusammenbauzustand angedeutet, bei dem eine Leiterplatine 1 an einem Montageträger 3 gefügt ist. Die Leiterplatine 1 und der Montageträger 3 sind z. B. Bestandteile eines Pulswechselrichters für die Antriebseinheit eines elektrisch betriebenen Fahrzeugs. Die Erfindung ist jedoch nicht auf diese spezielle Bauteilkombination begrenzt. Alternativ dazu kann die Erfindung auch auf andere ähnliche Bauteileumfänge angewendet werden, etwa auf Flachprofile, Bleche, Steckerelemente, geeignete Bauteile etc., die an einem Bauteilträger befestigbar sind. Fahrzeugs können aber auch andere ähnliche Bauteilumfänge umfassen. Gemäß der Figur 1 liegt die Leiterplatine 1 auf einer Sockelfläche 5 des Montageträgers 3. Von der Sockelfläche 5 ragt ein Materialdom 7 rechtwinklig nach oben ab, der mit Lochspiel durch eine Durchgangsbohrung 9 der Leiterplatine 1 geführt ist. Der Materialdom 7 weist einen, die Durchgangsbohrung 9 der Leiterplatine 1 überragenden, ausgeweiteten Materialdom-Kopf 11 auf. Zwischen dem Rand des ausgeweiteten Materialdom-Kopfes 11 und der Sockelfläche 5 ist daher ein Hinterschnitt gebildet, in dem die Leiterplatine 1 formschlüssig gehaltert ist. Gemäß der Figur 1 ist der Materialdom 7 mit einem an der Kopfoberseite offenen Hohlprofil 13 ausgebildet, das als ein Sackloch realisiert ist. Das Sackloch 13 schließt an einem, von der Kopfoberseite mit einer Sackloch-Tiefe beabstandeten Sackloch-Grund 15 ab, so dass der Materialdom 7 fußseitig mit Vollmaterial materialeinheitlich und einstückig in die Sockelfläche 5 des Montageträgers 3 übergeht. In der in der Figur 1 gezeigten Bauteilanordnung ist die Leiterplatine 1 mit einer vordefinierten Klemmkraft F_{K} zwischen dem Rand des ausgeweiteten Materialdom-Kopfes 11 und der Sockelfläche 5 verspannt. Der Montageträger 3 besteht aus einem Nichteisenmetall mit niedrigem Schmelzpunkt, etwa Aluminium, wodurch die Leiterplatine 1 über den Montageträger 3 in einfacher Weise geerdet werden kann.

Anhand der Figur 2 ist nachfolgend ein Verfahren zur Herstellung der in der Figur 1 gezeigten Bauteilverbindung veranschaulicht. Demnach wird zunächst die Leiterplatine 1 mit ihrer Durchgangsbohrung 9 auf den noch unverformten Materialdom 7 des Montageträgers 3 gesteckt. Der so gebildete lose Bauteilverbund wird dann in ein entsprechendes Werkzeug 16 auf dessen ortsfestes Werkzeugteil 17 gelegt. Das Werkzeug 16 weist außerdem einen hubverstellbaren Stempel 19 auf, der ggf. unter einer zusätzlich zugeführten Wärmebeaufschlagung mit einer axialen Fügekraft Fa, sowie unter Rotation gegen die Kopfoberseite des Materialdom-Kopfes 11 drückt. Durch die entstehende Reibungswärme wird der Materialdom-Kopf 11 plastifiziert.

Der Stempel 19 ist an seiner, dem Materialdom-Kopf 11 zugewandten Seite mit einer konisch zulaufenden Stempelspitze 21 ausgebildet. Diese ist derart bemessen, dass sie während des Fügevorgangs in das Hohlprofil 13 des Materialdoms 7 eintaucht und mit ihrem radial äußeren Mantel in Kontakt mit einer umlaufenden Profilkante 23 kommt, an der das Hohlprofil 13 in die Kopfoberseite übergeht. Beispielhaft kann der Stempel 19 zusätzlich über eine nicht dargestellte Heizeinrichtung beheizbar sein. In diesem Fall erfolgt während des Fügevorgangs eine Wärmeleitung von der stempelseitigen Heizeinrichtung in den Materialdom-Kopf 11, ein Aufweichen des Materialdom-Kopfes 11 zu unterstützen.

In der Figur 3 ist der Fügevorgang zu einem Prozesszeitpunkt gezeigt, zu dem der Stempel 19 nach Art eines Rührreibschweißens unter Rotation R mit der axialen Fügekraft F_{A} gegen die Kopfoberseite des Materialdom-Kopfes 11 gepresst ist. Mittels der dabei erzeugten Reibungswärme plastifiziert der Materialdom-Kopf 11 und weitet sich dieser aus, um den Hinterschnitt zu erzeugen.

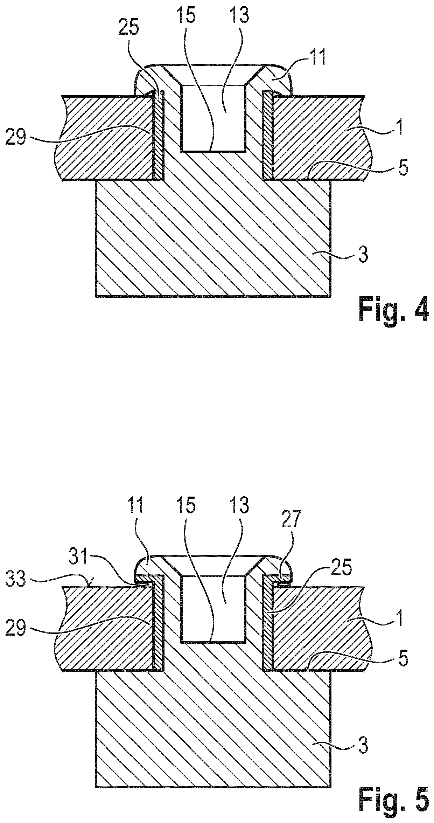

In der Figur 4 ist eine Bauteilverbindung gemäß einer weiteren Ausführungsvariante dargestellt, die im Wesentlichen mit der in der Figur 1 gezeigten Bauteilanordnung übereinstimmt. Zusätzlich ist in der Figur 4 eine Maßnahme zur Reduzierung der auf die Leiterplatine 1 wirkenden Klemmkraft F_{K} getroffen; d.h. der Materialdom 7 ist von einer Stützhülse 25 umgeben. Diese ist sowohl an der Unterseite des Rands des ausgeweiteten Materialdom-Kopfes 11 und der Sockelfläche 5 abgestützt. Dadurch kann die sich bei des Fügevorgangs aufbauende Klemmkraft F_{K} zumindest teilweise in die Stützhülse 25 eingeleitet werden, und zwar unter gleichzeitiger Entlastung des Öffnungsrandbereiches 29 der Durchgangsbohrung 9 der Leiterplatine 1.

In der Figur 5 geht die Stützhülse 25 an ihrer dem Materialdom-Kopf 11 zugewandten Stirnseite in einen rechtwinklig nach außen abragenden Stützflansch 27 über. Der Öffnungsrandbereich 29 der Durchgangsbohrung 9 der Leiterplatine 1 ist daher gemäß Figur 5 im Wesentlichen spannungsfrei in einem Inneneckbereich zwischen dem Stützflansch 27 und dem Außenumfang der Stützhülse 25 angeordnet. Zudem ist in der Figur 5 an der Unterseite des Stützflansches 27 ein Federelement 31 ausgebildet. Das Federelement 31 wirkt zwischen dem Stützflansch 27 der Stützhülse 25 und der Leiterplatinen-Oberseite 33 und begrenzt die auf die Leiterplatine 1 ausübbare Klemmkraft F_{K}.

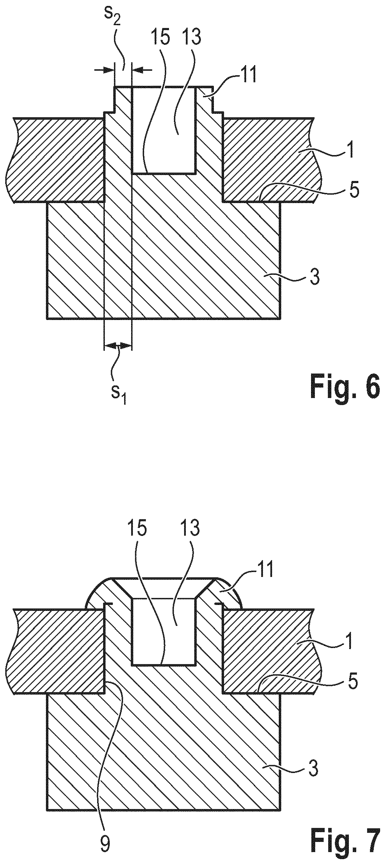

In der Figur 6 ist eine Bauteilverbindung gemäß einer weiteren Ausführungsvariante gezeigt, in der die Bauteilverbindung noch vor dem Fügevorgang gezeigt ist. Demzufolge weist der mit Hohlprofil 13 ausgebildete Materialdom 7 einen in der Durchgangsbohrung 9 der Leiterplatine 1 befindlichen Mittelbereich mit großer Hohlprofil-Wandstärke s₁ sowie durchmessergroßem Außenumfang auf. Ferner weist der Materialdom 7 den aus der Durchgangsbohrung 9 ragenden Materialdom-Kopf 11 mit demgegenüber reduzierter Hohlprofil-Wandstärke s₂ sowie durchmesserkleinem Außenumfang auf. Aufgrund der reduzierten Hohlprofil-Wandstärke s₂ sowie des durchmesserkleinem Außenumfangs des Materialdom-Kopfs 11 kann die beim Fügevorgang erforderliche axiale Fügekraft Fa, sowie die erforderliche Wärmebeaufschlagung vorteilhaft reduziert werden. In der Figur 7 ist der in der Figur 6 angedeutete, lose Bauteilverbund als fertiggestellte Bauteilanordnung gezeigt.

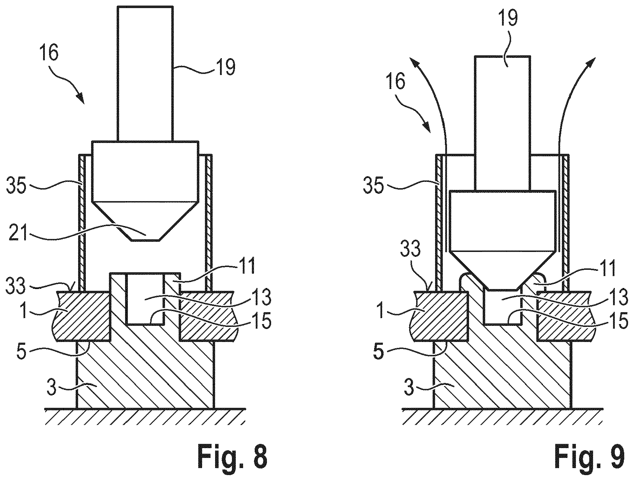

In den Figuren 8 und 9 ist ein weiteres Ausführungsbeispiel der Erfindung angedeutet. Demzufolge weist das Werkzeug 16 zusätzlich einen hohlzylindrischen bzw. hülsenförmigen Niederhalter 35 auf, der im Fügebereich mit einer Niederhalterkraft gegen die Leiterplatinen-Oberseite 33 drückt. Innerhalb des hohlzylindrischen Niederhalters 35 ist der Stempel 19 hubverstellbar angeordnet. Der Innenraum des hohlzylindrischen Niederhalters 35 ist an einer nicht dargestellten Saugeinrichtung angebunden, mittels der während des Fügevorgangs sich bildende Abgase bzw. Partikel abgesaugt werden können. Der Niederhalter 35 sorgt zudem für eine prozesssichere Abschirmung der Fügestelle nach außen.

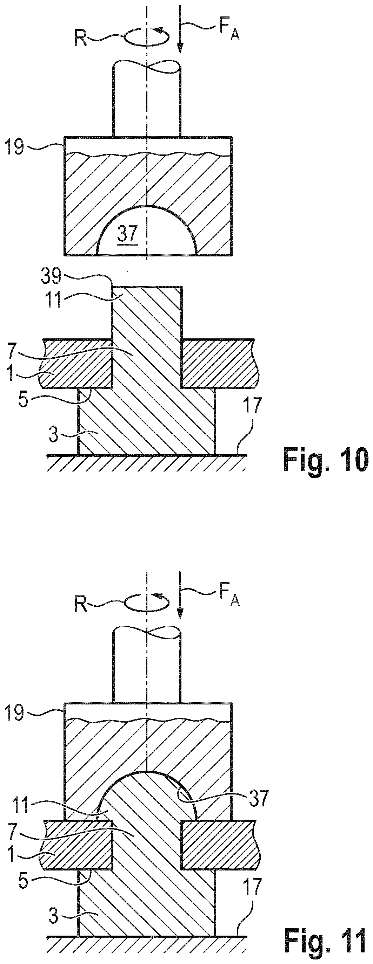

In den Figuren 10 und 11 ist eine weitere Ausführungsvariante gezeigt. Im Unterschied zu den vorangegangenen Figuren weist gemäß der Figur 10 der noch unverformte Materialdom 7 an seinem Materialdom-Kopf 11 kein offenes Hohlprofil 13 auf, sondern vielmehr ein geschlossenes Vollmaterial. Der hubverstellbare Stempel 19 des Werkzeugs 16 wird beim Fügeprozess ggf. unter einer zusätzlich zugeführten Wärmebeaufschlagung mit einer axialen Fügekraft Fa, sowie unter Rotation gegen die Kopfoberseite des Materialdom-Kopfes 11 gedrückt. Durch die entstehende Reibungswärme wird der Materialdom-Kopf 11 plastifiziert.

Der Stempel 19 ist an seiner, dem Materialdom-Kopf 11 zugewandten Seite mit einem sphärischen Hohlprofil 37 ausgebildet. Das sphärische Stempel-Hohlprofil 37 ist derart bemessen, dass der Materialdom-Kopf 11 während des Fügevorgangs in das Stempel-Hohlprofil 37 eintaucht und mit seiner radial äußeren, umlaufenden Profilkante 39 in Kontakt mit der Innenfläche des sphärischen Stempel-Hohlprofils 37 kommt. Beispielhaft kann der Stempel 19 - wie auch in den vorangegangenen Ausführungsbeispielen - zusätzlich über eine nicht dargestellte Heizeinrichtung beheizbar sein.

In der Figur 11 ist der Fügevorgang zu einem Prozesszeitpunkt gezeigt, zu dem der Stempel 19 nach Art eines Rührreibschweißens unter Rotation R mit der axialen Fügekraft F_{A} gegen die Kopfoberseite des Materialdom-Kopfes 11 gepresst ist. Mittels der dabei erzeugten Reibungswärme plastifiziert der Materialdom-Kopf 11 und weitet sich dieser aus, um den Hinterschnitt zu erzeugen.

### Bezugszeichenliste

- 1: Leiterplatine
- 3: Montageträger
- 5: Sockelfläche
- 7: Materialdom
- 9: Durchgangsbohrung der Leiterplatine 1
- 11: Materialdom-Kopf
- 13: Hohlprofil
- 15: Sackloch-Boden
- 16: Werkzeug
- 17: ortsfestes Werkzeugteil
- 19: Stempel
- 21: Stempelspitze
- 23: Profilkante
- 25: Stützhülse
- 27: Stützflansch
- 29: Öffnungsrandbereich
- 31: Federelement
- 33: Leiterplatinen-Oberseite
- 35: Niederhalter
- 37: sphärisches Stempel-Hohlprofil
- 39: umlaufende kopfseitige Profilkante
- s₁, s₂: Wandstärken
- F_{K}: Klemmkraft
- F_{A}: axiale Fügekraft

## Patentansprüche

1. Bauteilanordnung mit einem Bauteil, etwa einer Leiterplatine (1), das an einen Bauteilträger (3), insbesondere aus einem Nichteisenmetall mit niedrigem Schmelzpunkt, etwa Aluminium, gefügt ist, wobei das Bauteil (1) auf einer Sockelfläche (5) des Bauteilträgers (3) liegt, von der ein Materialdom (7) abragt, der durch eine Durchgangsbohrung (9) des Bauteils (1) geführt ist, **dadurch gekennzeichnet, dass** ein die Durchgangsbohrung (9) des Bauteils (1) überragender Materialdom-Kopf (11) im Fügeprozess nach Art eines Rührreibschweißens oder einer anderen/ ähnlichen Art zur Temperaturerzeugung durch Reibung (durch Rotation und Anpressdruck) oder auch mit einer anderen Form der Temperaturerzeugung plastifizierbar ist, so dass sich der Materialdom-Kopf (11) ausweitet, wodurch zwischen dem Rand des ausgeweiteten Materialdom-Kopfes (11) und der Sockelfläche (5) ein Hinterschnitt gebildet ist, in dem das Bauteil (1) formschlüssig gehaltert ist.

2. Bauteilanordnung nach Anspruch 1, **dadurch gekennzeichnet, dass** der Materialdom (7) an seinem Materialdom-Kopf (11) aus Vollmaterial ausgebildet ist, oder dass der Materialdom (7) ein an der Kopfoberseite offenes Hohlprofil (13) aufweist, etwa ein Sackloch, das mit einer Sackloch-Tiefe an einem Sackloch-Grund (15) abschließt, oder ein Durchgangsloch.

3. Bauteilanordnung nach Anspruch 1 oder 2, **dadurch gekennzeichnet, dass** in dem nach Art eines Rührreibschweißens erfolgenden Fügeprozess ein Stempel (19) unter Rotation sowie mit einem Anpressdruck bzw. einer axialen Fügekraft (F_{A}) gegen die Kopfoberseite des Materialdom-Kopfes (11) drückt, um diesen unter Plastifizierung aufzuweiten.

4. Bauteilanordnung nach Anspruch 3, **dadurch gekennzeichnet, dass** der Stempel (19) an seiner dem Materialdom-Kopf (11) zugewandten Seite eine konisch zulaufende Stempelspitze (21) aufweist, und dass die Stempelspitze (21) derart bemessen ist, dass sie während des Fügevorgangs in das Hohlprofil (13) des Materialdoms (7) eintaucht und mit ihrem radial äußeren Mantel den Öffnungsrandbereich des Materialdom-Kopfes (11) radial nach außen drückt, oder dass
der Stempel (19) an seiner, dem Materialdom-Kopf (11) zugewandten Seite mit einem sphärischen Hohlprofil (37) ausgebildet ist, und dass das sphärische Stempel-Hohlprofil (37) ist derart bemessen, dass der Materialdom-Kopf (11) während des Fügevorgangs in das Stempel-Hohlprofil (37) eintaucht und mit seiner umlaufenden kopfseitigen Profilkante (39) in Kontakt mit der Innenfläche des sphärischen Stempel-Hohlprofils (37) kommt.

5. Bauteilanordnung nach Anspruch 3 oder 4, **dadurch gekennzeichnet, dass** der Stempel (19) während des Fügeprozesses mittels einer zusätzlichen Heizeinrichtung beheizbar ist, so dass eine Plastifizierung des Materialdom-Kopfes (11) unterstützt wird.

6. Bauteilanordnung nach einem der vorhergehenden Ansprüche, **dadurch gekennzeichnet, dass** in der gefügten Bauteilanordnung die Leiterplatte (1) mit einer Klemmkraft (F_{K}) zwischen dem Rand des ausgeweiteten Materialdom-Kopfes (11) und der Sockelfläche (5) verspannt ist, und dass insbesondere zur Reduzierung der auf das Bauteil (1) wirkenden Klemmkraft (F_{K}) der Materialdom (7) von einer Stützhülse (25) umgeben ist, die zwischen der Unterseite des Rands des ausgeweiteten Materialdom-Kopfes (11) und der Sockelfläche (5) abgestützt ist, wodurch die sich beim Fügevorgang aufbauende Klemmkraft (F_{K}) zumindest teilweise in die Stützhülse (25) einleitbar ist.

7. Bauteilanordnung nach Anspruch 6, **dadurch gekennzeichnet, dass** die Stützhülse (25) an ihrer dem Materialdom-Kopf (11) zugewandten Stirnseite in einen rechtwinklig nach außen abragenden Stützflansch (27) übergeht, und dass insbesondere ein Öffnungsrandbereich (29) der Durchgangsbohrung (9) des Bauteils (1) im wesentlichen spannungsfrei in einem Inneneckbereich zwischen dem Stützflansch (27) und dem Außenumfang der Stützhülse (25) angeordnet ist, dass insbesondere zwischen dem Rand des ausgeweiteten Materialdom-Kopfes (11) und einer von der Sockelfläche (5) abgewandten Leiterplatinen-Seite (33) ein Federelement (31) angeordnet ist, und dass insbesondere das Federelement (31) materialeinheitlicher und/oder einstückiger Bestandteil des Stützflansches (27) der Stützhülse (25) ist.

8. Bauteilanordnung nach einem der Ansprüche 2 bis 7, **dadurch gekennzeichnet, dass** der mit Hohlprofil (13) ausgebildete Materialdom (7) einen in der Durchgangsbohrung (9) des Bauteils (1) befindlichen Mittelbereich mit großer Hohlprofil-Wandstärke (s₁) und den Materialdom-Kopf (7) mit demgegenüber reduzierter Hohlprofil-Wandstärke (s₂) aufweist, wodurch der im Fügevorgang erforderliche Anpressdruck (F_{A}) sowie die erforderliche Wärmebeaufschlagung reduzierbar ist.

9. Werkzeug (16) zur Herstellung einer Bauteilanordnung mit einer Leiterplatine (1), die an einen Bauteilträger (3), insbesondere aus einem Nichteisenmetall mit niedrigem Schmelzpunkt, etwa Aluminium, gefügt ist, wobei das Bauteil (1) auf einer Sockelfläche (5) des Bauteilträgers (3) liegt, von der ein Materialdom (7) abragt, der durch eine Durchgangsbohrung (9) des Bauteils (1) geführt ist, **dadurch gekennzeichnet, dass** ein die Durchgangsbohrung (9) des Bauteils (1) überragender Materialdom-Kopf (11) im Fügeprozess nach Art eines Rührreibschweißens oder einer anderen/ ähnlichen Art zur Temperaturerzeugung durch Reibung (durch Rotation und Anpressdruck) oder auch mit einer anderen Form der Temperaturerzeugung plastifizierbar ist, so dass sich der Materialdom-Kopf (11) ausweitet, und dass zwischen dem Rand des ausgeweiteten Materialdom-Kopfes (11) und der Sockelfläche (5) ein Hinterschnitt gebildet ist, in dem das Bauteil (1) formschlüssig gehaltert ist, dass insbesondere das Werkzeug (16) einen hülsenförmigen Niederhalter (35) aufweist, in dessen Innenraum der Stempel (19) hubverstellbar angeordnet ist, dass insbesondere während des Fügevorgangs der Niederhalter (35) im Fügebereich mit einer Niederhaltekraft gegen das Bauteil (1) drückt, und dass insbesondere der Stempel (19) unter Anpressdruck (F_{A}) und Rotation gegen die Kopfoberseite des Materialdoms (7) drückt.

10. Verfahren zur Herstellung einer Bauteilanordnung, die an einen Bauteilträger (3), insbesondere aus einem Nichteisenmetall mit niedrigem Schmelzpunkt, etwa Aluminium, gefügt ist, wobei das Bauteil (1) auf einer Sockelfläche (5) des Bauteilträgers (3) liegt, von der ein Materialdom (7) abragt, der durch eine Durchgangsbohrung (9) des Bauteils (1) geführt ist, **dadurch gekennzeichnet, dass** ein die Durchgangsbohrung (9) des Bauteils (1) überragender Materialdom-Kopf (11) im Fügeprozess nach Art eines Rührreibschweißens oder einer anderen/ ähnlichen Art zur Temperaturerzeugung durch Reibung (durch Rotation und Anpressdruck) oder auch mit einer anderen Form der Temperaturerzeugung plastifiziert wird, so dass sich der Materialdom-Kopf (11) ausweitet, und dass zwischen dem Rand des ausgeweiteten Materialdom-Kopfes (11) und der Sockelfläche (5) ein Hinterschnitt gebildet wird, in dem das Bauteil (1) formschlüssig gehaltert ist.
